**Europäisches Patentamt**

**European Patent Office**

**Office européen des brevets**

(19)

(11) Veröffentlichungsnummer: **0 002 191**
**B1**

(12) **EUROPÄISCHE PATENTSCHRIFT**

(45) Veröffentlichungstag der Patentschrift:
04.11.81

(51) Int. Cl.³: **H 01 L 27/02**, H 01 L 21/82,
H 01 L 29/72

(21) Anmeldenummer: 78101288.5

(22) Anmeldetag: 02.11.78

(54) Integrierte Halbleiteranordnung in I2L-Technik und Verfahren zur Herstellung derselben.

(30) Priorität: 30.11.77 US 855869

(43) Veröffentlichungstag der Anmeldung:
13.06.79 Patentblatt 79/12

(45) Bekanntmachung des Hinweises auf die Patenterteilung:
04.11.81 Patentblatt 81/44

(84) Benannte Vertragsstaaten:
DE FR GB

(56) Entgegenhaltungen:
FR-A-2 301 922
FR-A-2 334 198
GB-A-1 362 345
IBM TECHNICAL DISCLOSURE BULLETIN, Band 13, Juli 1970, New York,
R. R. WILCOX »Two diffusion bipolar monolithic structure«, Seite 305
IBM TECHNICAL DISCLOSURE BULLETIN, Band 18, September 1975, New York,
A. BHATTACHARYYA et al. »Ion implantation of bipolar transistors having different characteristics«, Seiten 1023—1024
IBM technical disclosure bulletin, Band 18, Dezember 1975, New York,

(73) Patentinhaber: International Business Machines Corporation, Armonk, N.Y. 10504 (US)

(72) Erfinder: Bergeron, David Leo, 7606 Wedgewood Drive, Manassas, Va. 22110 (US)
Erfinder: Putney, Zimri Congdon, 5102 Gunpowder Road, Fairfax, Va. 22030 (US)
Erfinder: Stephens, Geoffrey Brownell, 10 Mercer Court, Catlett, Va. 22019 (US)

(74) Vertreter: Gaugel, Heinz, Dipl.-Ing., Schönaicher Strasse 220, D-7030 Böblingen (DE)

R. C. JAEGER »Base charge reduction in merged transistor logic structures«, Seiten 2388—2389
IEEE JOURNAL OF SOLID STATE CIRCUITS, Band SC-12, April 1977, New York,
F. HENNIG et al. »Isoplanar integrated injection logic: A highperformance bipolar technology«, Seiten 101—109
IBM TECHNICAL DISCLOSURE BULLETIN Band 20, August 1977, New York,
D. J. FLEMING »Inverse transistor structure«, Seiten 1087—1088
IBM TECHNICAL DISCLOSURE BULLETIN, Band 20, August 1977, New York,
H. H. BERGER et al. »Reducing the carrier storage in collector base junctions«, Seiten 1051—1053
IBM TECHNICAL DISCLOSURE BULLETIN Band 20, September 1977, New York,
T. H. NING et al, »Process for fabrication of buried emitter transistors, Seite 1616

## Integrierte Halbleiteranordnung in I²L-Technik und Verfahren zur Herstellung derselben

Die Erfindung betrifft eine integrierte Halbleiteranordnung in I²L-Technik mit invers betriebenem, vertikalem und damit strukrurell verschmolzenem, komplementärem, lateralem Transistor, die aktive Zone in einem an die Oberfläche angrenzenden Teil einer auf ein Substrat aufgebrachten und an der Grenze zum Substrat eine vergrabene, die Emitterzone des vertikalen Transistors bildende, hochdotierte Zone eines ersten Leitungstyps aufweisenden Epitaxieschicht desselben Leitungstyps enthält bei der in der Epitaxieschicht die Basiszone des vertikalen Transistors vom zweiten Leitungstyp und in der Basiszone die Kollektorzone des vertikalen Transistors vom ersten Leitungstyp angeordnet ist und bei der in dem unterhalb der aktiven Zonen liegenden Bereich der Epitaxieschicht durch Ionenimplantation eine Implantationszone des zweiten Leitungstyps eingebracht ist, durch die der Leitungstyp dieses Bereiches kompensiert wird. Ferner betrifft sie ein Verfahren zur Herstellung dieser integrierten Halbleiteranordnung.

Integrierte Halbleiteranordnungen mit bipolaren, invers betriebenen, vertikalen und lateralen Transistoren sind insbesondere in unter der Bezeichnung I²L (Integrated Injection Logic) oder MTL (Merged Transistor Logic) bekanntgewordenen Schaltungen zu finden. Bei den bekannten Halbleiteranordnungen dieser Art ist der Nachteil festzustellen, daß der Emitter des invers betriebenen, vertikalen Transistors nur einen niedrigen Injektionswirkungsgrad aufweist und daß im Emitter-Basisbereich ein nicht zu vernachlässigender Ladungsspeichereffekt auftritt. Man ist deshalb gezwungen, den niedrigen Injektionswirkungsgrad durch einen größeren Kollektor auszugleichen und infolge der Ladungsspeicherung längere Schaltzeiten in Kauf zu nehmen.

Im »IEEE Journal of Solid State Circuits«, Juni 1976, ist auf der Seite 379 unter dem Titel »High Speed Integrated Injection Logic« eine entsprechende Anordnung beschrieben, bei der die Basiszone des vertikalen NPN-Transistors durch eine Implantation von Bor hoher Energie und niedriger Dosis bis in den $N^+$-Subemitter ausgedehnt ist, um dadurch die Ausdehnung der $N^-$-Epitaxieschicht auf ein Minimum zu bringen. Die Maßnahme führt zu einer Verringerung der Ladungsspeicherung im Emitter-Basisübergang. Bei dieser Anordnung wird jedoch nicht zwischen dem extrinsischen und dem intrinsischen Basiszonenbereich unterschieden, so daß sich keine Möglichkeit eröffnet, das Basiszonenprofil so einzustellen, daß die Diffusion der Elektronen im intrinsischen Basiszonenbereich ohne störende Beeinflussung der Injektion und Kapazität im extrinsischen Basiszonenbereich begünstigt werden könnte.

Aus der Veröffentlichung »IBM Technical Disclosure Bulletin«, Vol. 18, Nr. 4, Sept. 1975, Seiten 1023/1024 ist es bekannt durch eine selektiv geöffnete Maskierungsschicht und ihre Öffnungen hindurch einen Halbleiterkörper mit Ionen zu implantieren, um in einem einzigen Implantationsschritt getrennte Zonen mit Konzentrationsmaxima von unterschiedlicher Tiefe herzustellen.

Aus »IEEE Journal of Solid-State Circuits«, Vol. SC-12, Nr. 2, April 1977, Seiten 101 bis 109 ist der erste Teil des Anspruchs 1 bekannt. Ferner ist es hieraus bekannt, die intrinsischen Basisbereiche in Richtung auf die vergrabene Emitterzone auszudehnen, um die Schaltzeiten herabzusetzen, und die Dotierung des zweiten Leitungstyps in den extrinsischen Basisbereichen zu erhöhen, um die Speicherung von Minoritätsladungsträgern herabzusetzen.

In der DE-A-2 813 154 ist ein Verfahren zur Herstellung von MTL-Strukturen vorgeschlagen worden mit einem $N^+$-Substrat-Emitter, einer P-Epitaxieschicht, einer abgesenkten Oxidisolation, einer lateralen N-Basiszone und mit $N^+$-Kollektoren, wobei ebenfalls eine entsprechende Implantation vorgenommen wird. Dabei wird über die Dicke einer Oxidschicht/Nitrid-Maskierungsschicht das Dotierungsprofil so eingestellt, daß es unter dem intrinsischen Basiszonenbereich völlig innerhalb des $N^+$-Substrat-Emitters zu liegen kommt, während es im extrinsischen Basiszonenbereich an das $N^+$-Substrat angrenzt. Durch diese Maßnahme wird das bei dieser Anordnung angestrebte Ziel erreicht und es wird durch Verwendung einer P-Epitaxieschicht das Problem der Ladungsspeicherung weitgehend verhindert. Nachteilig ist, daß durch den eingegangenen Kompromiß die Eigenschaften des konventionellen NPN-Transistors verschlechtert werden. Die unerwünschte Minoritätsträger-Injektion im extrinsischen Basiszonenbereich wird durch Erhöhung des Dotierungsprofils in diesem Bereich verhindert. Es kann jedoch das Dotierungsprofil im intrinsischen Basiszonenbereich nicht so eingestellt werden, daß die Diffusion von Elektronen unterstützt und damit die Diffusionskapazität vermindert wird, da das einem Kurzschluß zwischen dem Kollektor und dem Emitter des lateralen PNP-Transistors gleichkäme. Außerdem ist bei dieser Anordnung eine automatische Selbstausrichtung zwischen Kollektorzone des vertikalen Transistors und der implantierten Zone nicht möglich, was für das Erreichen hochwertiger und extrem dichter Anordnungen Voraussetzung wäre.

Hier will die Erfindung Abhilfe schaffen. Die Erfindung, wie sie in den Ansprüchen gekennzeichnet ist, löst die Aufgabe, bei einem invers betriebenen, vertikalen Transistor den Widerstand im extrinsischen Basiszonenbereich zu reduzieren und gleichzeitig im intrinsischen Basiszonenbereich den Emitterwirkungsgrad zu erhöhen, bei einem doppeltdiffundierten, lateralen Transistors den Kollektorwirkungsgrad zu erhöhen und diese Maßnahmen bei Verwendung beider Transistortypen im Rahmen einer I$^2$L-Struktur ohne zusätzlichen Aufwand gleichzeitig zu verwirklichen.

Die durch die Erfindung erreichten Vorteile sind im wesentlichen darin zu sehen, daß insbesondere im Rahmen einer I$^2$L-Struktur beim vertikalen Transistor der Ladungsspeichereffekt und die Emitter-Diffusionskapazität reduziert und die Emitterwirksamkeit erhöht wird und beim lateralen Transistor der Ladungsspeichereffekt reduziert und der Kollektorwirkungsgrad erhöht wird.

Im folgenden wird die Erfindung anhand von lediglich einen Ausführungsweg darstellenden Zeichnungen näher erläutert.

Es zeigen:

Fig. 1 eine Schnittansicht einer I$^2$L-Struktur in einer ersten Stufe des Herstellungsverfahrens, wobei in konventioneller Weise ein unterer, vergrabener Teil einer P+-Isolationszone, eine vergrabene N+ Zone und eine N⁻-Epitaxieschicht vorgesehen ist,

Fig. 2 eine Schnittansicht der Struktur in einer zweiten Stufe des Herstellungsverfahrens, wobei sämtliche Fenster für Kontakte, eine N-Schutzringzone und eine Basiszone des PNP-Transistors in die Siliciumnitridschicht eingebracht sind,

Fig. 3 eine Draufsicht der Struktur gemäß Fig. 2,

Fig. 4 eine Schnittansicht der Struktur in einer dritten Stufe des Herstellungsverfahrens, bei der unter Verwendung einer Photolack-Sperrmaske, die N-Schutzringzone, die Basiszone und die Anschlußzone zur vergrabenen N+-Zone implantiert werden,

Fig. 5 eine Schnittansicht der Struktur in einer vierten Stufe des Herstellungsverfahrens, bei der mittels einer Photolack-Sperrmaske durch Ionenimplantation die Basiszone des NPN-Transistors, die Kollektorzone des PNP-Transistors und die oberen Isolationszonen eingebracht werden,

Fig. 6 eine Schnittansicht der Struktur in einer fünften Stufe des Herstellungsverfahrens, in der über eine Photolack-Sperrmaske sämtliche Fenster für die Kontakte geöffnet werden,

Fig. 7 eine Draufsicht der Struktur gemäß Fig. 6 nach dem Öffnen der Fenster für die Kontakte,

Fig. 8 eine Schnittansicht der Struktur in einer sechsten Stufe des Herstellungsverfahrens, bei der über eine Photolack-Sperrmaske durch Ionenimpantation N+-Zonen eingebracht werden, die die N+-Kollektoren des vertikalen NPN-Transistors und die ohmschen Anschlußzonen zur Basis des PNP-Transistors bzw. zum vergrabenen Emitter des NPN-Transistors bzw. zu den Schutzringzonen bilden,

Fig. 9 eine Schnittansicht der Struktur in einer siebten Stufe des Herstellungsverfahrens, bei der über eine Photolack-Sperrmaske durch Ionenimplantation der Emitter des PNP-Transistors und die Anschlußzonen zum Kollektor des PNP-Transistors bzw. zur Basis des NPN-Transistors gebildet werden und

Fig. 10 eine Schnittansicht der Struktur in einer achten Stufe des Herstellungsverfahrens, bei der über eine Photolack-Sperrmaske durch Ionenimplantation das Dotierungsprofil im Gebiet zwischen der Basis und dem vergrabenen Emitter des vertikalen NPN-Transistors erfindungsgemäß beeinflußt wird.

In einem bevorzugten Ausführungsbeispiel betrifft die Erfindung eine verbesserte, integrierte Injektionslogik (I$^2$L), wobei durch die erfindungsgemäßen Maßnahmen die Minoritätsträger-Ladungsspeicherung reduziert und der Emitterwirkungsgrad des inversen, vertikalen NPN-Transistors erhöht wird. Die I$^2$L-Struktur wird in einer N-Epitaxieschicht durch selektive Maskierung mit Photolack, selektive Oxidation und Ionenimplantation hergestellt. Dabei bleibt ein restlicher Zonenbereich der schwach dotierten N⁻-Epitaxieschicht zwischen dem vergrabenen Subemitter und der Basis des vertikalen NPN-Transistors erhalten. Dieser Restbereich zwischen Basis und Subemitter ist erforderlich, um bei anderen, normalbetriebenen, auf demselben Halbleitersubstrat integrierten Transistoren eine ausreichend hohe Kollektor-Emitterspannung aufrecht zu erhalten. Durch die erfindungsgemäße Maßnahme wird diese N⁻-Epitaxieschicht im Bereich der I$^2$L-Struktur durch selektive Maskierung mit Photolack und Implantation von Borionen kompensiert, so daß der Spitzenwert des implantierten Profils dem Verlauf der Oberfläche der Anordnung folgt. Dieses Profil reicht im Bereich der geöffneten Kontaktfenster und insbesondere im Bereich der Fenster für die Kollektoren des vertikalen Transistors weiter in die Struktur hinein als in den übrigen Bereichen. Die Energie wird so gewählt, daß das Maximum des implantierten Profils an der Kante des vergrabenen Subemitters liegt. Die obere Hälfte des implantierten Profils kompensiert die N⁻-Epitaxieschicht. Die tieferliegende untere Hälfte des implantierten Profils wird vom vergrabenen Subemitter des vertikalen Transistors kompensiert. Das verbleibende P-Basisprofil ist damit in einer Richtung abgestuft, die die Injektion von Elektronen auf dem Subemitter unterstützt. Gleichzeitig gelangt das Maximum des Dotierungsprofils in den mit Oxid-Nitridschichten bedeckten Bereichen weniger weit in das Silicium hinein. Das Maximum liegt hier zwischen der P-Basis und dem vergrabenen N+-Emitter, so daß die Injektion von Elektronen gehemmt und die Emitter-Basis-Ladungsspeicherung in diesen Bereichen reduziert wird. Die Fläche des lateralen Kollektors des mit dem vertikalen Transistor verschmolzenen lateralen PNP-Transistors wird durch die Ausdehnung der Basis des vertikalen NPN-Transistors bis zur vergrabenen N+-Zone erhöht, was zu einer Vergrößerung des Kollektorwirkungsgrades und der Stromverstärkung des lateralen PNP-Transistors führt.

Es wird also die Struktur und die Herstellung einer Halbleiteranordnung beschrieben, bei der gleichzeitig NPN- und PNP-Transistoren mit günstigen Eigenschaften hinsichtlich der Ladungsspeicherung und der vertikalen Injektion erzielt werden. Dabei wird die Oberflächenkontur der integrierten Anordnung ausgenutzt, um in automatisch angepaßter, veränderlicher Tiefe durch Ionenimplantation eine Zone bilden, durch die die Injektion erhöht und die Ladungsspeicherung reduziert wird. Das angewandte Verfahren ist vereinbar mit dem Verfahren zur Herstellung von Schottky-Dioden und konventionell arbeitenden Transistoren, da die erforderliche Implantation nur im Bereich der Transistoren der I²L-Struktur durchgeführt wird.

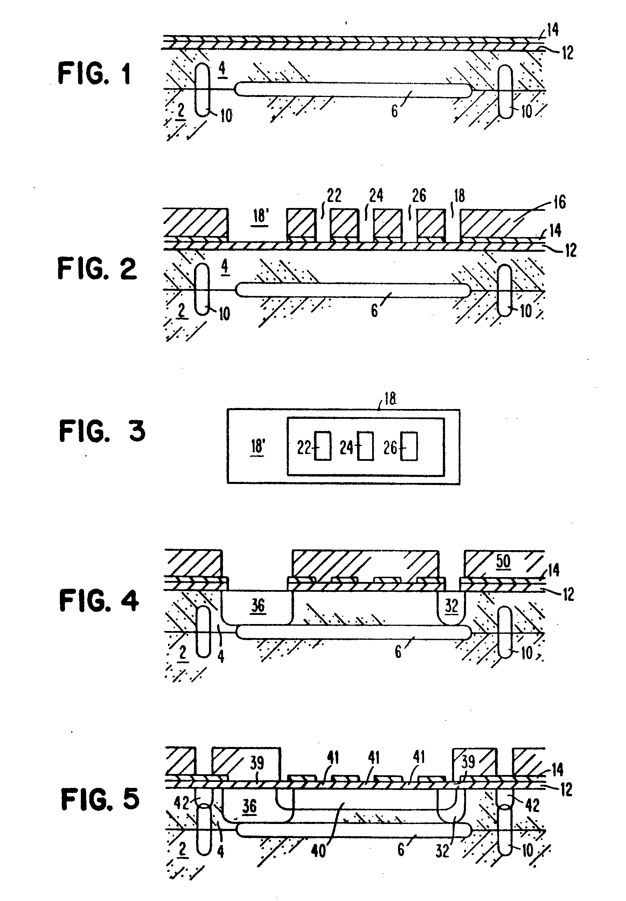

Die Struktur gemäß Fig. 1 ist in konventioneller Weise durch Maskierung, Dotierung (Diffusion oder Ionenimplantation) und geeignete Beschichtungstechniken hergestellt, wobei ausgehend von einem Substrat 2 eine N⁻-Epitaxieschicht 4, vergrabene P⁺-Isolationszonen 10 und eine vergrabene N⁺-Zone 6 entstehen. Die Oberfläche der Epitaxieschicht 4 ist mit einer Oxidschicht 12 gefolgt von einer Siliciumnitridschicht 14 beschichtet.

In der Struktur gemäß Fig. 2 ist einer Photolackmaske 16 vorhanden, die als Ätzmaske zum Öffnen der Fenster 18 für die Schutzringzone bzw. 18′ für die Basis des PNP-Transistors und für sämtliche Kontaktfenster 22, 24, 26 in der Siliciumnitridschicht 14 dient.

Die Fig. 3 zeigt die Photolackmaske in Draufsicht.

In der nächsten Verfahrensstufe (Fig. 4) ist eine Photolack-Sperrmaske 50 aufgebracht, die sowohl als Ätzmaske als auch als Implantationsmaske dient. Zunächst wird im Bereich der Maskenfenster die Siliciumdioxidschicht 12 abgeätzt. Anschließend erfolgt im Bereich der Fenster die Implantation von Phosphor. Dabei entsteht eine N-dotierte Zone, die als Anschlußzone 36 zur vergrabenen N⁺-Zone 6, als die Gesamtstruktur umgebende Schutzringzone 32 und als Basiszone 36 des lateralen PNP-Transistors dient. Die Implantation wird mit relativ niedriger Energie durchgeführt, so daß die Fenster 18 und 18′ in der Oxid/Nitridschicht die Ausdehnung der implantierten Zonen bestimmen. Anschließend wird durch Reoxidation die Siliciumdioxidschicht 39 im Bereich der Maskenfenster gebildet (Fig. 5). Dabei diffundieren die N-Zonen 32 und 36 aus und kontaktieren die ebenfalls ausdiffundierte, vergrabene N⁺-Zone 6. Die Oxidschicht 41 in den Kontaktbereichen 22, 24 und 26 wächst während dieses Reoxidationsprozesses um einen geringeren Betrag, so daß dort der Energieverlust bei der nachfolgenden Ionenimplantation etwa äquivalent ist dem Energieverlust in der Doppelschicht 12, 14 aus Siliciumdioxid und Siliciumnitrid.

Gemäß Fig. 5 werden dann unter Verwendung einer Photolack-Sperrmaske durch Ionenimplantation von Bor doppelter Energie wie zuvor die oberen Isolationszonen 42 und als gemeinsame P-Zone 40 die Basiszone des NPN-Transistors und die Kollektorzone des PNP-Transistors gebildet. Da diese Zonen 40 und 42 durch die Oxidschicht 39, 41 bzw. die Oxidschicht 12 und die Nitridschicht 14 implantiert werden, ist die Tiefe des Überganges der Basiszone 40 eine Funktion der Dicke der Oxidschicht 41 in den Kontaktgebieten 22, 24, 26 und eine Funktion der Doppelschichten 12 und 14 aus Oxid und Nitrid in den übrigen Bereichen. Hält man die Dicke der Nitridschicht 14 im Vergleich zur Dicke der Oxidschicht 39 relativ gering, können Unterschiede in der Tiefe des Überganges der Basiszone 40 relativ gering gehalten werden, außerdem kann dadurch eine Verdünnung der Basiszone 40 im Bereich der Ecken der Kollektorzonen 54 des vertikalen NPN-Transistors vermieden werden.

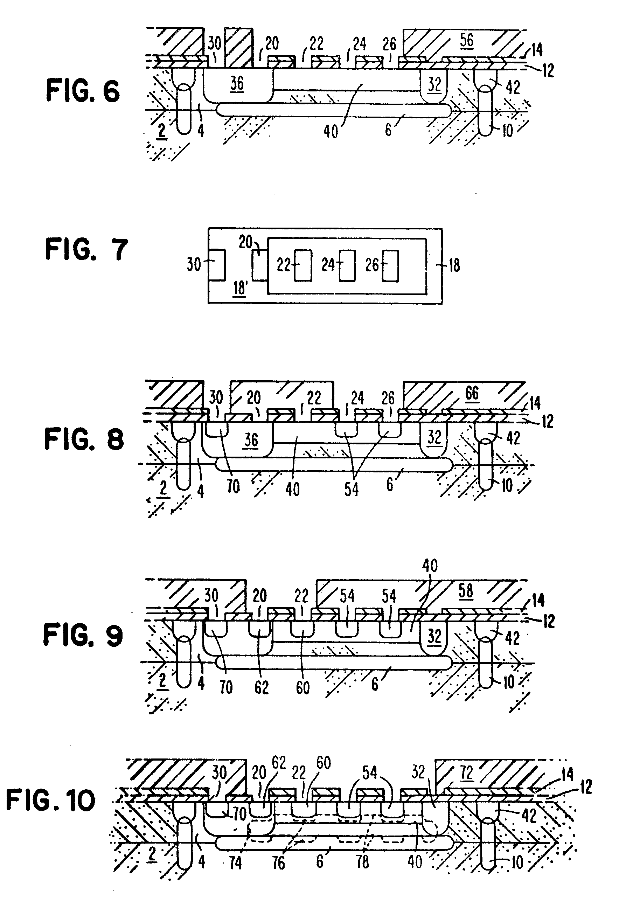

Wie der Fig. 6 zu entnehmen ist, wird nunmehr eine Photolack-Sperrmaske 56 benutzt, um die N-Schutzringzonen 32 abzudecken, während gleichzeitig in der Siliciumdioxidschicht 12 sämtliche Kontaktbereiche 20, 22, 24, 26 und 30 geöffnet werden. Die Maske 56 definiert außerdem das Fenster 30 für den Basisanschluß des PNP-Transistors und das Fenster 20 für den Emitter des PNP-Transistors.

In Fig. 7 ist eine Draufsicht der durch die Nitridschicht definierten Fenster 22, 24 und 26 und der durch die Nitridschicht/Photolackschicht definierten Fenster 20, 30 dargestellt. Die zuvor definierten Fenster in der Siliciumnitridschicht dienen als Ätzmaske für eine oder mehrere Seiten der Bereiche 30, 20, während die Photolack-Sperrmaske 56 die anderen Seiten definiert.

In den beiden nächsten Maskierungsschritten wird wiederum eine Photolack-Sperrmaske als Implantationsmaske verwendet, dabei kann die Reihenfolge der Verfahrensschritte vertauscht werden.,

1. Fig. 8 zeigt die Photolack-Sperrmaske 66, mit Hilfe der beispielsweise durch Implantation von Arsen die N⁺-Kollektoren 54 des vertikalen NPN-Transistors und die Basisanschlußzone 70 des lateralen PNP-Transistors gebildet werden. Dabei werden die Zonen definiert durch die Fenster in der Siliciumnitridschicht 14 und der Siliciumdioxidschicht 12.

2. Fig. 9 zeigt die Verwendung einer Photolack-Sperrmaske 58, mit Hilfe der durch Implantation von beispielsweise Bor die P⁺-Basis des vertikalen NPN-Transistors bzw. der Kollektorkontakt 60 des lateralen PNP-Transistors und der Emitter 62 des lateralen PNP-Transistors gebildet werden. Auch hier sind die Zonen definiert durch die Fenster in der Siliciumnitridschicht 14 und der Siliciumdioxidschicht 12.

Im Anschluß an diese Implantationsprozesse erfolgt der übliche Erwärmungsprozeß, bei dem die implantierten Zonen aktiviert und die gebildeten N⁺- und P⁺-Zonen bis zu ihrer endgültigen Tiefe ausgedehnt werden.

Fig. 10 offenbart den das wesentlichste Merkmal der Erfindung darstellenden Schritt. Es wird eine Photolack-Sperrmaske 72 verwendet, die das Gebiet definiert, in dem eine Zone 74 durch Implantation von beispielsweise Bor einzubringen ist. Die Implantation erfolgt mit einer ausreichenden Energie, so daß das Maximum des Dotierungsprofils in einer Tiefe liegt, die der oberen Kante des vergrabenen N+-Emitters 6 unterhalb der intrinsischen Basis 76 entspricht. Das Maximum des Dotierungsprofils verläuft außerdem im Mittelbereich der N⁻-Epitaxieschicht zwischen der Basis 40 und dem vergrabenen Emitter 6 im Bereich der extrinsischen Basis 78. Dies erreicht man durch geeignete Wahl der Dicke der Oxidschicht bzw. Nitridschicht, der vertikalen Übergangstiefen und der Dicke der Epitaxieschicht.

Bei einer Übergangstiefe der Basis von 0,5 µm, einer Dicke des verbliebenen Bereiches der N⁻-Epitaxieschicht von 0,2 µm und einer Dicke der Oxidschicht/Nitridschicht von 100 nm/ 500 nm ist eine Energie von 3000 keV für die Borimplantation geeignet. Die Dosis kann zwischen $10^{12}$ bis $10^{14}$ Ionen/cm² gewählt werden, wobei sich die gewünschten Verstärkungseigenschaften ergeben. Nach Ablösen der Photolack-Sperrmaske 72 erfolgt eine Erwärmung auf 900°C bei einer Dauer von 30 Min. in einer inerten Atmosphäre. Die erforderliche Aktivierung erfolgt hierbei ohne merkliche Ausdiffusion der Zonen.

Solange die Konzentration der Borimplantation im Bereich der Zone 74 geringer als die Konzentration der Basis 36 des lateralen PNP-Transistors und der Schutzringzone 32 ist, ist innerhalb der I²L-Struktur während der Implantation keine Maskierung erforderlich, da die Schutzringzone die benachbarten Basiszonen isoliert. Unter dieser Voraussetzung handelt es sich bei der Photolack-Sperrmaske 72 um eine unkritische Maske, da sie lediglich den nicht zur eigentlichen I²L-Struktur gehörenden Bereich ausblendet.

Zusammenfassend kann festgestellt werden, die Erfindung liefert eine verbesserte I²L-Struktur, die mittels einer unkritisch zu maskierenden Implantation von beispielsweise Bor eine ausgedehnte Basis des vertikalen NPN-Transistors ergibt. Diese ausgedehnte Basis erhöht die Elektroneninjektion im intrinsischen Bereich und eine verminderte Elektroneninjektion und reduzierte Ladungsspeicherung im extrinsischen Bereich.

**Patentansprüche**

1. Integrierte Halbleiteranordnung in I²L-Technik mit invers betriebenem, vertikalem und damit strukturell verschmolzenem, komplementärem, lateralem Transistor, die aktive Zonen in einem an die Oberfläche angrenzenden Teil einer auf ein Substrat (2) aufgebrachten und an der Grenze zum Substrat eine vergrabene, die Emitterzone des vertikalen Transistors bildende, hochdotierte Zone (6) eines ersten Leitungstyps aufweisenden Epitaxieschicht (4) desselben Leitungstyps enthält, bei der in der Epitaxieschicht (4) die Basiszone (40) des vertikalen Transistors vom zweiten Leitungstyps und in der Basiszone (40) die Kollektorzone (54) des vertikalen Transistors vom ersten Leitungstyps angeordnet ist und bei der in dem unterhalb der aktiven Zonen liegenden Bereich der Epitaxieschicht (4) durch Ionenimplantation eine Implantationszone (74) des zweiten Leitungstyps eingebracht ist, durch die der Leitungstyp dieses Bereiches kompensiert wird, dadurch gekennzeichnet, daß das Konzentrationsmaximum der Implantationszone (74) im intrinsischen Basiszonenbereich an der Grenzfläche zur Emitterzone (6) und im extrinsischen Basiszonenbereich zwischen Basiszone (40) und Emitterzone (6) liegt.

2. Integrierte Halbleiteranordnung nach Anspruch 1, dadurch gekennzeichnet, daß sie einen doppeltdiffundierten lateralen Transistor (62, 36, 40) mit an die Oberfläche der Epitaxieschicht angrenzenden aktiven Zonen enthält, der eine Basiszone (36) des ersten Leitungstyps, eine Emitterzone (62) des zweiten Leitungstyps in der Basiszone (36) und eine lateral an die Basiszone (36) angrenzende, gleichzeitig die Basiszone des vertikalen Transistors (6, 40, 54) bildende Kollektorzone (40) des zweiten Leitungstyps aufweist, wobei die Implantationszone (74) die Kollektorzone (40) des lateralen Transistors ausdehnt.

3. Verfahren zur Herstellung der Halbleiteranordnung insbesondere nach Anspruch 1 oder 2, dadurch gekennzeichnet, daß die Basiszone (40) des vertikalen Transistors über der vergrabenen Emitterzone (6) in die Oberfläche der Epitaxieschicht (4) eingebracht wird, daß auf die Oberfläche der Epitaxieschicht (4) eine Isolationsschicht (12, 14) mit einem Maskenfenster im Bereich der einzubringenden Kollektorzone (54) des vertikalen Transistors aufgebracht wird und daß dann durch diese selektiv geöffnete Isolationsschicht (12, 14) und ihre Öffnungen hindurch Ionenimplantation durchgeführt wird, wobei aufgrund des den intrinsischen Basiszonenbereich definierenden Maskenfensters und der Bereiche der Isolationsschicht (12, 14) über den extrinsischen Basiszonenbereichen der angestrebte Konzentrationsverlauf in der Epitaxieschicht (4) unterhalb der Basiszone (40) des vertikalen Transistors erreicht wird.

4. Verfahren zur Herstellung der Halbleiteranordnung insbesondere nach Anspruch 2, dadurch gekennzeichnet, daß die gleichzeitig die Kollektorzone des lateralen Transistors bildende Basiszone (40) des vertikalen Transistors in die Oberfläche der Epitaxieschicht (4) eingebracht wird, daß seitlich an die Basiszone (40) des vertikalen Transistors angrenzend die Basiszone (36) des lateralen Transistors in die Oberfläche der Epitaxieschicht (4) eingebracht wird, daß die Emitterzone (62) des lateralen Transistors in die Basiszone (36) eingebracht wird, daß auf die Oberfläche der Epitaxieschicht (4) eine Isolationsschicht (12, 14) mit einem Maskenfenster im Bereich der einzubringenden Kollektorzone (54) des vertikalen Transistors aufgebracht wird und daß dann durch diese selektiv geöffnete Isolationsschicht (12, 14) und ihre Öffnungen hindurch die lonenimplantation durchgeführt wird, bei der die für beide Transistoren gemeinsame Implantationszone (74) eingebracht wird.

## Claims

1. Integrated semiconductor arrangement utilizing integrated injection logic (I2L) technology employing upward injecting vertical transistors and, in structural connection therewith, complementary lateral transistors, comprising active zones in a region bordering the surface of an epitaxial layer (4) of a first conductivity type, deposited on a substrate, and, at the surface of the substrate, a buried highly doped zone (6) forming the emitter zone of a vertical transistor of the first conductivity type, wherein the base zone (40) of the first conductivity type vertical transistor in arranged in the epitaxial layer (4) and the collector zone (54) of the vertical transistor of the first conductivity type is arranged in the base zone (40), and wherein an ion implantation zone (74) of the second conductivity type is introduced by ion implantation into the region of the epitaxial layer (4) beneath the active zones, whereby the conductivity type of this region is compensated, characterised in that the concentration peak of the implantation zone (74) is positioned in the intrinsic base zone region at the border to the emitter zone (6) and in the extrinsic base zone region between base zone (40) and emitter zone (6).

2. Integrated semiconductor arrangement according to claim 1, characterised in that it comprises a double diffused lateral transistor (62, 36, 40) with active zones bordering the surface of the epitaxial layer, said transistor comprising a base zone (36) of the first conductivity type, an emitter zone (62) of the second conductivity type in the base zone (36) and a collector zone (40) of the second conductivity type, laterally bordering the base zone (36) and simultaneously forming the base zone of the vertical transistor (6, 40, 54), wherein the implantation zone (74) extends the collector zone (40) of the lateral transistor.

3. Process for the production of a semiconductor arrangement, especially according to claim 1 or 2, characterised in that the base zone (40) of the vertical transistor is formed above the buried emitter zone (6) in the surface of the epitaxial layer (4), that an isolating layer (12, 14) is deposited on the surface of the epitaxial layer (4) having a mask window in the region where the vertical transistor collector zone (54) is to be formed and that ion implantation is subsequently performed through the window and selectively positioned other openings in the isolating layer (12, 14), wherein the desired concentration contour in the epitaxial layer (4) beneath the base zone (40) of the vertical transistor is achieved due to the mask window defining the intrinsic base zone region and to the masking portions of the isolating layer (12, 14) defining the extrinsic base zone regions.

4. Process for the production of a semiconductor arrangement, especially according to claim 2, characterised in that the base zone (40) of the vertical transistor simultaneously providing the collector zone of the lateral transistor, is introduced into the surface of the epitaxial layer (4), that the base zone (36) of the lateral transistor, laterally bordering the base zone (40) of the vertical transistor, is introduced into the surface of the epitaxial layer (4), that the emitter zone (62) of the lateral transistor is introduced in the base zone (36), that an isolating layer (12, 14) including a mask window in the region of the vertical transistor collector zone (54) to be formed is deposited on the surface of the epitaxial layer (4), and that subsequently ion implantation is performed through these selectively opened isolating layers (12, 14) and their windows, in which process step the implantation zone (74) common for both transistors is introduced.

## Revendications

1. Dispositif semi-conducteur intégré dans la technique I2L avec un transistor vertical fonctionnant en inverse et, structurellement lié avec celui-ci, un transistor latéral complémentaire, du genre comportant: des zones actives dans une partie adjacente à la surface d'une couche épitaxiale (4) d'un premier type de conductivité déposée sur un substrat (2) et une région enterrée, fortement dopée (6) du même type de conductivité, formant la région d'émetteur du transistor vertical disposée à la frontière du substrat; une région de base (40) du transistor vertical, du second type de conductivité disposée dans la couche épitaxiale (4) et dans la région de base (40) la région de collecteur (54) du transistor vertical du premier type de conductivité; une région implantée (74) du second type de conductivité formée par implantation ionique dans la région de la couche épitaxiale (4) située en-dessous des zones actives, le type de conductivité de cette région étant ainsi compensé; ledit dispositif étant caractérisé en ce que le pic de concentration maximum de la région implantée (74) est situé dans la zone de région de base intrinsèque, à la frontière de la région d'émetteur (6) et dans la zone de la région de base extrinsèque située entre la région de base (40) et la région d'émetteur (6).

2. Dispositif semi-conducteur intégré selon la revendication 1, caractérisé en ce qu'il comporte un transistor latéral à double diffusion (62, 36, 40) avec des zones actives adjacentes à la surface

de la couche épitaxiale; ce transistor comprend une région de base (36) du premier type de conductivité, une région d'émetteur (62) du second type de conductivité dans la région de base (36) ainsi qu'une région de collecteur (40) du second type de conductivité latéralement adjacente à la région de base (36) et formant simultanément la région de base du transistor vertical (6, 40, 54), la région implantée (74) prolonge la région de collecteur (40) du transistor latéral.

3. Procédé pour fabriquer le dispositif semi-conducteur en particulier selon la revendication 1 ou 2, caractérisé en ce que la région de base (40) du transistor vertical est réalisée dans la surface de la couche épitaxiale (4) au-dessus de la région d'émetteur enterrée (6); en ce que l'on dépose sur la surface de la couche épitaxiale (4), une couche isolante (12, 14) munie d'une ouverture de masquage dans la zone de la région de collecteur à diffuser (54) du transistor vertical; et en ce que l'on procède ensuite à une implantation ionique à travers cette ouverture décapée sélectivement dans cette couche isolante (12, 14), dont le profil de concentration désiré dans la couche épitaxiale (4), en-dessous de la région de base (40) du transistor vertical, est obtenu grâce à l'ouverture de masquage définissant la zone de région de base intrinsèque et aux portions de la couche isolante (12, 14) disposées au-dessus des régions de base extrinsèque.

4. Procédé pour fabriquer le dispositif semi-conducteur en particulier selon la revendication 2, caractérisé en ce que la région de base (40) du transistor vertical, formant également la région de collecteur du transistor latéral, est réalisée dans la surface de la couche épitaxiale (4); en ce que la région de base (36) du transistor latéral, latéralement adjacente à la région de base (40) du transistor vertical, est réalisée dans la surface de la couche épitaxiale (4), en ce que la région d'émetteur (62) du transistor latéral est réalisée dans la région de base (36), en ce qu'une couche isolante (12, 14) ayant une ouverture de masquage dans la zone de la région de collecteur (54) du transistor vertical à former ultérieurement est déposée sur la surface de la couche épitaxiale (4); et en ce que l'on implante ensuite à travers l'ouverture pratiquée sélectivement dans la couche isolante (12, 14), des ions pour obtenir la région implantée (74) commune aux deux transistors.

**FIG. 1**

**FIG. 2**

**FIG. 3**

**FIG. 4**

**FIG. 5**

FIG. 6

FIG. 7

FIG. 8

FIG. 9

FIG. 10